(19) **Europäisches Patentamt / European Patent Office / Office européen des brevets**

(11) **EP 3 788 393 B1**

(12) # FASCICULE DE BREVET EUROPEEN

(45) Date de publication et mention de la délivrance du brevet:
**10.07.2024 Bulletin 2024/28**

(21) Numéro de dépôt: **19730191.4**

(22) Date de dépôt: **30.04.2019**

(51) Classification Internationale des Brevets (IPC):
**G01R 33/563** (2006.01)  **G01R 33/58** (2006.01)
**G01R 33/56** (2006.01)

(52) Classification Coopérative des Brevets (CPC):
**G01R 33/56308; G01R 33/5608; G01R 33/58**

(86) Numéro de dépôt international:
**PCT/FR2019/051001**

(87) Numéro de publication internationale:
**WO 2019/211556 (07.11.2019 Gazette 2019/45)**

(54) **FANTÔME ET MÉTHODOLOGIE DESTINÉS À L'ÉTALONNAGE ET AU CONTRÔLE QUALITÉ DES SYSTÈMES D'IMAGERIE PAR RÉSONNANCE MAGNÉTIQUE CLINIQUE POUR LES MESURES DE VÉLOCIMÉTRIE PAR SÉQUENCE DITE DE FLUX 4D**

PHANTOM UND VERFAHREN ZUR KALIBRIERUNG UND QUALITÄTSKONTROLLE VON KLINISCHEN MAGNETRESONANZBILDGEBUNGSSYSTEMEN FÜR GESCHWINDIGKEITSMESSUNGEN MITTELS 4D-DURCHFLUSSSEQUENZ

PHANTOM AND METHOD FOR THE CALIBRATION AND QUALITY CONTROL OF CLINICAL MAGNETIC RESONANCE IMAGING SYSTEMS FOR VELOCIMETRY MEASUREMENTS BY 4D FLOW SEQUENCE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.05.2018 FR 1853827**

(43) Date de publication de la demande:
**10.03.2021 Bulletin 2021/10**

(73) Titulaire: **SPIN UP**
**67960 Entzheim (FR)**

(72) Inventeurs:
• **MENDEZ, Simon**
**34000 Montpellier (FR)**
• **NICOUD, Franck**
**34160 Restinclieres (FR)**
• **MORENO, Ramiro**
**67960 Entzheim (FR)**
• **PUISEUX, Thomas**
**67960 Entzheim (FR)**
• **SEWONU, Kwadzo Anou**
**67960 Entzheim (FR)**

(74) Mandataire: **IP Trust**
**2, rue de Clichy**
**75009 Paris (FR)**

(56) Documents cités:
**US-B1- 6 205 871**

• **CHIH-YUNG WEN ET AL: "Investigation of Pulsatile Flowfield in Healthy Thoracic Aorta Models", ANNALS OF BIOMEDICAL ENGINEERING, KLUWER ACADEMIC PUBLISHERS-PLENUM PUBLISHERS, NE, vol. 38, no. 2, 5 November 2009 (2009-11-05), pages 391 - 402, XP019765897, ISSN: 1573-9686**
• **VARIUS: "Jeudi 12 Octobre Journée de Formation pluri-professionnelle", 13 October 2017 (2017-10-13), pages 19pp, XP055609694, Retrieved from the Internet <URL:https://jfr.radiologie.fr/files/files/JFR2017/Programme%20du%20GRIC%20-%20V3%20avec%20r%C3%A9sum%C3%A9s.pdf>**
• **THOMAS PUISEUX ET AL: "Reconciling PC-MRI and CFD: An in-vitro study", NMR IN BIOMEDICINE., vol. 32, no. 5, 12 February 2019 (2019-02-12), GB, pages e4063, XP055609652, ISSN: 0952-3480, DOI: 10.1002/nbm.4063**

**(Cont. page suivante)**

- KHODARAHMI IMAN: "Comparing velocity and fluid shear stress in a stenotic phantom with steady flow: phase-contrast MRI, particle image velocimetry and computational fluid dynamics", MAGNETIC RESONANCE MATERIALS IN PHYSICS, BIOLOGY AND MEDICINE, SPRINGER, DE, GB, vol. 28, no. 4, 12 December 2014 (2014-12-12), pages 385 - 393, XP035520210, ISSN: 0968-5243, [retrieved on 20141212], DOI: 10.1007/S10334-014-0476-X
- MICHAEL MARKL ET AL: "Time-resolved three-dimensional phase-contrast MRI", JOURNAL OF MAGNETIC RESONANCE IMAGING, vol. 17, no. 4, 19 March 2003 (2003-03-19), US, pages 499 - 506, XP055223723, ISSN: 1053-1807, DOI: 10.1002/jmri.10272
- BALEDENT ET AL: "Modelisation des flux cerebraux par une analogie electrique : validation par velocimetrie IRM", MEDECINE NUCLEAIRE, ELSEVIER, PARIS, FR, vol. 31, no. 1, 7 April 2007 (2007-04-07), pages 16 - 28, XP022376666, ISSN: 0928-1258, DOI: 10.1016/J.MEDNUC.2006.04.001

**Description**

Domaine de l'invention

La présente invention concerne l'imagerie de flux par Imagerie par Résonance Magnétique (IRM).

L'IRM dite « 4D flow » permet de fournir aux cliniciens de diverses spécialités médicales (cardiologie, neurologie, vasculaire), par une technique d'imagerie non-invasive et non-ionisante, des informations sur l'hémodynamique dans le volume exploré. Ces informations aident à la prise en charge des patients.

Par IRM «4D Flow» ou « CVMR » (cardio vascular magnetic resonance) on entend une acquisition par résonance magnétique qui produit une cartographie du champ de vitesses dans le volume exploré, obtenue par la technique d'imagerie par contraste de phase, qui a ici les trois composantes de la vitesse au cours du temps.

Cette technique d'imagerie existe depuis plus de dix ans mais son utilisation en clinique courante est difficile à cause d'un temps d'acquisition trop long. Par ailleurs, la valeur de la vitesse est encodée en niveaux de gris sur la base d'une vitesse maximale ou « vitesse d'encodage ». Cette valeur doit être choisie avant l'acquisition. Si elle est trop faible pour le cas étudié, un phénomène d'aliasing se présentera, si elle est trop élevée, le contraste dans l'image sera très faible avec une perte de précision sur la mesure. Des acquisitions avec plusieurs niveaux d'encodage (multi-venc) sont disponibles mais sont encore plus longues en temps d'acquisition. Des avancées récentes ayant permis une accélération des acquisitions volumiques (gradients magnétiques plus rapides, sous-échantillonnage du signal recueilli), ont ouvert la possibilité d'étendre les indications de l'IRM aux informations fonctionnelles du type hémodynamique.

Toutefois, même si ces cartographies de vitesse sont de plus en plus utilisées en clinique, rien ne garantit que les mesures affichées soient fiables. En d'autres termes, à notre connaissance il n'existe pas de « gold standard » pour contrôler que ces mesures sont fidèles à l'hémodynamique du phénomène physique observé. De plus, les contrôles de qualité proposés par le constructeur ou par les référents chez l'exploitant de l'IRM, ne couvrent pas ce domaine d'application.

La présente invention comble cette lacune car elle propose un écoulement de référence parfaitement connu qui représente l'étalon par rapport auquel l'IRM testée devra être évaluée.

Les séquences par contraste de phase constituent la base des techniques d'IRM de flux 4D et utilisent le déphasage des protons présents dans le flux pour créer un contraste dans l'image. Ce contraste est proportionnel à la vitesse de déplacement du flux contenant ces protons. Le contraste dans l'image sera encodé selon la « vitesse d'encodage » mentionnée plus haut. Les données obtenues peuvent fournir des mesures qualitatives (visualisation du flux) et quantitatives (paramètres hémodynamiques). Les informations qualitatives indiquent la direction du flux dans chaque voxel. La topographie du flux peut être définie de façon précise en générant des lignes de passage de flux (lignes de courant) dérivées du champ de vitesse, ce qui produit un aperçu des flux dominants par tractographie virtuelle des flux.

Les mesures quantitatives comprennent la valeur inscrite dans la cartographie du champ de vitesse, mais aussi d'autres cartographies dérivées du champ de vitesse qui définissent l'hémodynamique du phénomène. On peut citer parmi les plus importantes les cartes de contraintes (pression hydrostatique - normale à la paroi- et forces de cisaillement - tangentielles à la paroi). Ces cartes de contraintes (wall stress ou WS et wall shear stress ou WSS) correspondent aux efforts que le flux circulant exerce sur la paroi qui le contient. On retrouve actuellement nombreux logiciels d'analyse de ces cartographies de flux obtenues par IRM 4D Flow. Certains sont déjà capables de calculer les cartes de contrainte à partir des données de vitesse. Cependant, si les données fournies à ces logiciels sont fausses, toutes les cartographies dérivées reconstruites derrière le seront davantage.

La présente invention se sert d'une technologie numérique largement utilisée dans l'industrie aéronautique et automobile pour modéliser des phénomènes complexes. A partir d'un phénomène hémodynamique bien posé numériquement, un modèle réel est fabriqué et reproduit à l'identique dans un modèle expérimental (fantôme de flux 4D) à l'intérieur de l'IRM. La différence entre le modèle numérique et les cartographies IRM permet de quantifier les erreurs produites durant l'acquisition IRM. La modélisation numérique pour sa part, permet de résoudre les équations de mécanique des fluides dans un domaine défini numériquement. La solution calculée est cohérente en tout point du volume modélisé et ceci pour les variables de vitesse et de pression, car elles sont définies dans les équations de dynamique. La Mécanique des Fluides Numérique (MFN) ou en anglais Computational Fluid Dynamics (CFD) permet de modéliser un champ d'écoulement de référence capable d'être reproduit à l'identique sous forme d'un modèle physique réel. Ce couple numérique / physique permet d'évaluer les performances de l'acquisition IRM avec un écoulement connu a priori.

Etat de la technique

On connaît dans l'état de la technique les demandes internationales WO2015109254 et WO2017091835 déposées par le système « Arterys » qui proposent de corriger certains artéfacts liés à la technique d'imagerie (aliasing, courant de Foucault, ..), d'isoler les structures anatomiques (par segmentation automatique) et de reconstruire les cartographies tirées des acquisitions 4D flow. Ce système met à disposition le traitement des données sur serveur distant (Cloud) accessible depuis n'importe quelle station de travail. L'IRM ou les IRM connectées, envoient les données vers ce serveur et le clinicien peut les consulter de façon sécurisée afin d'effectuer son diagnostic sur la base des paramètres mesurés. Le système possède entre autres des algorithmes basés sur l'intelligence artificielle (IA) pour déterminer les contours des organes ou proposer des mesures selon le type de diagnostic recherché. Le système permet de faire des analyses qualitatives (observation des lignes de courant) et quantitatives (mesures de grandeurs hémodynamiques).

On connaît aussi le brevet américain US7063942 décrivant un système de simulation hémodynamique comprenant un vaisseau ayant les propriétés d'un vaisseau sanguin, un réservoir contenant une quantité de fluide, un tube reliant le vaisseau et le réservoir, et au moins une pompe pour faire circuler le fluide dans le système.

Le fluide peut être un milieu de culture tissulaire ou un fluide analogue du sang, et le vaisseau peut comprendre des cellules mammaliennes attachées à son intérieur. Un système d'entraînement, comprenant deux arbres d'entraînement alternatifs couplés par une came, permet le désaccouplement de l'écoulement pulsatile et de la pression pulsatile pour fournir un contrôle indépendant de la contrainte de cisaillement de la paroi et de la déformation circonférentielle. L'arbre entraîne deux pompes qui sont déphasées de 180 degrés et sont raccordées en amont et en aval de la cuve, et effectuent ce désaccouplement.

Un autre exemple de solution de l'art antérieur est décrit dans le brevet américain US6205871. Ce brevet décrit un des matériaux et des procédés de modélisation de vaisseaux sanguins humains et notamment des fantômes d'artère carotide. Il propose la fabrication de fantômes vasculaires précis par stéréolithographie avec une représentation de jeu de données d'entrée d'une surface vasculaire pour construire un fantôme vasculaire anatomiquement précis comprenant une représentation physique de la surface.

On connaît aussi l'article « comparing velocity and fluid shear stress in a stenotic phantom with steady flow : phase contrast-MRI, particle image velocimetry and computational fluid dynamics" paru dans la revue Magn Reson Mater Phy (2015) 28:385-393 concernant une technique d'imagerie appliquée à un segment tubulaire présentant une restriction.

On connaît aussi la publication Wen CY, Yang AS, Tseng LY, Chai JW. Investigation of pulsatile flowfield in healthy thoracic aorta models. Ann Biomed Eng. 2010 Feb;38(2):391-402. doi: 10.1007/s10439-009-9835-6. Epub 2009 Nov 5. PMID: 19890715 concernant une étude expérimentale et numérique conjointe a été menée dans cette étude pour déterminer les distributions de la contrainte et de la pression de cisaillement de la paroi et de l'indice WSS oscillatoire, et d'examiner leur corrélation avec les troubles aortiques, en particulier la dissection ainsi que la publication Moreno et al « flux 4D et mécanique des fluides numériques 'CFD' Paris 2017 Congrès international d'imagerie médicale 13 octobre 2017.

Inconvénient de l'art antérieur

Les solutions de l'art antérieur ne sont pas satisfaisantes car aucune ne propose un écoulement de référence qui évalue l'écart présenté par l'hémodynamique entre un écoulement réel et celui mesuré par IRM. La solution proposée par Arterys traite les données qui lui sont envoyées mais n'a pas la capacité de contrôler la fiabilité des données qui lui sont transmises. Les informations exploitées sont essentiellement qualitatives (lignes de courants), la quantification des paramètres obtenus, tels que les débits et les contraintes, contient une erreur qui reste incertaine sans contrôle de qualité, et qui est intrinsèque aux paramètres de séquence (taille de voxel, vitesse d'encodage, méthodes d'échantillonnage du signal) et aux caractéristiques physiques de l'équipement (gradients, sensibilité d'antenne, homogénéité des champs magnétique). Ce manque de confiance est en somme le handicap principal pour cette modalité d'imagerie qui peut être une réponse certaine dans la décision de prise en charge du patient. Les autres brevets cités fixent des méthodes pour fabriquer des fantômes avec des caractéristiques physiques et de surface voisines à celles retrouvées in-vivo. Mais à notre connaissance, aucun dispositif ne propose la dualité modèle numérique/modèle physique afin de créer un étalon de référence.

Le taux d'erreur dépend du réglage de l'équipement IRM et de différents paramètres mal maîtrisés, qui ne permettent pas de tirer des enseignements cliniques fiables.

Or, les informations fournies au clinicien sont déterminantes pour décider d'un mode de traitement adapté, par exemple pour arbitrer entre un traitement médicamenteux ou une intervention chirurgicale. A titre d'exemple pour une pathologie telle qu'une fuite mitrale d'une valve, une prise en charge du patient inappropriée, telle que la décision de remplacer la valve plutôt que de prescrire un traitement médicamenteux, peut entraîner des conséquences vitales.

Le but de l'invention est de fournir une solution pour objectiver la qualité des informations fournies et le degré de confiance que le clinicien peut associer à son diagnostic pour en tirer des enseignements cliniques.

Solution apportée par l'invention

L'invention concerne selon son acception la plus générale un procédé de caractérisation du degré de confiance des données de flux IRM conforme à la revendication 1.

On entendra par « séquence de flux 4D » au sens du présent brevet une séquence à écho de gradient avec destruction de l'aimantation transverse (RF spoiling) et gradients bipolaires d'encodages des vitesses dans les trois directions de l'espace, telle que décrite par exemple dans la publication suivante : Markl, M. et al., (2003), Time-resolved three-dimensional phase-contrast MRI. J. Magn. Reson. Imaging, 17: 499-506. doi:10.1002/jmri.10272

L'invention concerne aussi l'utilisation du procédé de caractérisation susvisé pour :

- caractériser les performances d'une séquence d'acquisition ou
- la mise au point d'un dispositif médical par une évaluation numérique du modèle numérique, précédent une validation expérimentale du modèle physique.

Description détaillée d'un exemple non limitatif de l'invention

La présente invention sera mieux comprise à la lecture de la description détaillée d'un exemple non limitatif de l'invention qui suit, se référant aux dessins annexés où :

- la figure 1 représente une vue schématique d'un fantôme physique utilisé dans un procédé selon l'invention,

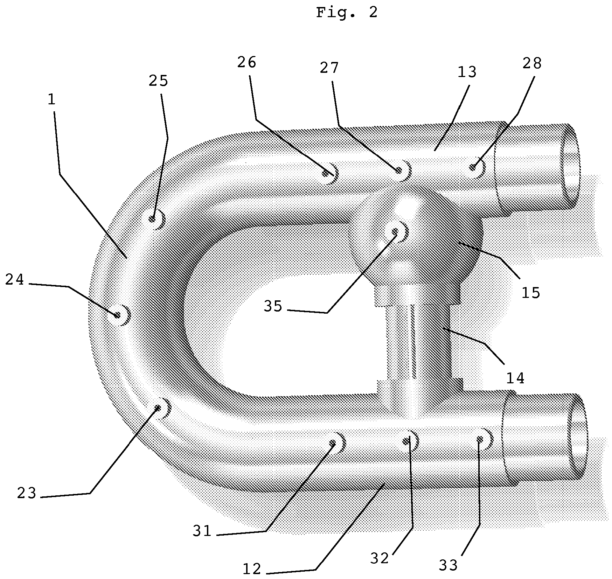

- la figure 2 représente une vue en perspective d'un fantôme utilisé dans un procédé selon l'invention,

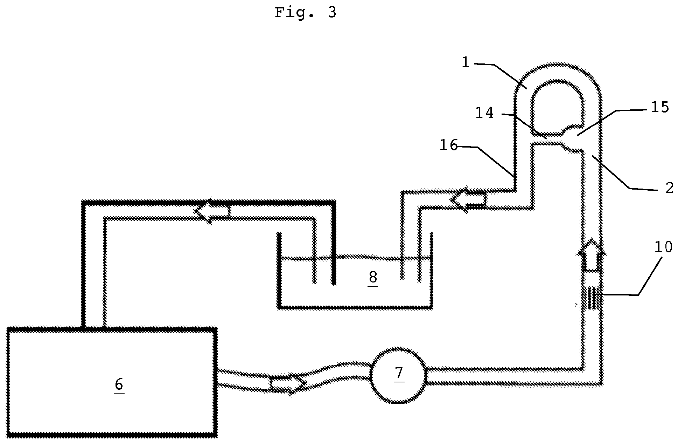

- la figure 3 représente une vue schématique du système d'alimentation du fantôme,
- la figure 4 représente le diagramme fonctionnel de l'invention,

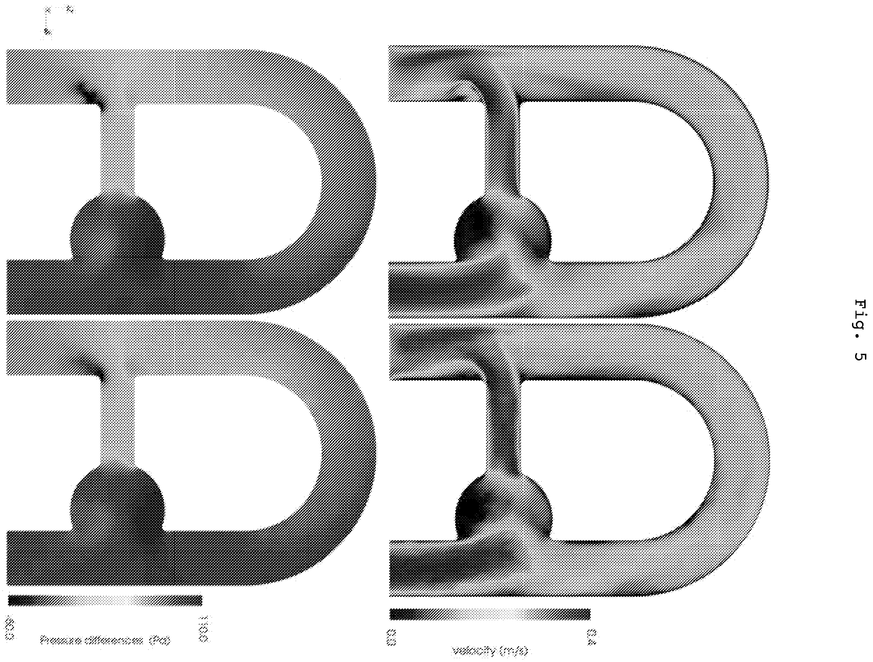

- la figure 5 représente une vue de la représentation graphique d'une image acquise avec un fantôme physique par un équipement IRM (image de droite) et l'image avec un fantôme numérique (image de gauche).

Contexte général de l'invention

Le but de l'invention est de fournir une (ou plusieurs) information(s) fiable(s) et objective(s) concernant le niveau de confiance qu'un clinicien ou un opérateur d'un équipement IRM peut apporter aux données d'imagerie hémodynamique, afin de déterminer la pertinence des informations obtenues lors d'un diagnostic basé sur une exploration par imagerie type « 4D-Flow ».

Pour cela, l'invention concerne un procédé permettant de tester un équipement IRM exécutant une séquence d'imagerie en présence d'un fantôme qui présente un écoulement de référence. Cet écoulement qui est bien réel est parfaitement connu par modélisation par mécanique des fluides numérique, ce qui lui confère son caractère d'écoulement de référence ou d'écoulement étalon.

Ce fantôme permet de tester la performance des mesures de vélocimétrie obtenues quand on utilise en clinique les séquences de flux 4D en IRM. Il regroupe dans un même objet test les caractéristiques suivantes :

- il est compatible avec une analyse par IRM
- il est transportable
- sa géométrie est parfaitement connue à priori car la même CAO est utilisée pour fabriquer le fantôme par impression 3D et pour générer les simulations
- sa forme est représentative des écoulements cardio-vasculaires (pour cette version du fantôme) : le fantôme regroupe une multiplicité de situations d'écoulement représentatives de l'hémodynamique du patient :

  - zone d ' écoulement " laminaire " (sections droites)
  - zone d' écoulement "turbulent" (anévrisme)
  - zone de décollement de l' écoulement (courbure)
  - zone de séparation de flux (bifurcation - collatérale).

Pour cela, on définit un fichier numérique de conception d'un fantôme de circulation de fluide, et on réalise à partir de ce fichier numérique un couple de référence formé par un fantôme numérique obtenu par traitement numérique dudit fichier de conception et un modèle physique réalisé par un procédé de fabrication piloté par ledit fichier numérique de conception. Le fantôme numérique constitue donc un clone dématérialisé du fantôme physique.

Le fantôme garantit une maîtrise des conditions limites en regroupant toutes les zones décrites plus haut dans un seul circuit muni d'une seule entrée et d'une seule sortie. Le résultat de la modélisation est donc piloté uniquement par la forme du modèle sans avoir à rajouter des conditions limites pour la répartition des flux. La présence d'une bifurcation associée à une surface de sortie unique permet d'avoir une répartition des débits uniquement dépendante des lois de mécanique des fluides, et donc indépendante des conditions limites imposées par l'utilisateur.

Ce fantôme physique est placé dans l'équipement d'IRM avec une alimentation contrôlée qui satisfait les conditions de débit correspondant aux paramètres du modèle numérique étalon.

La comparaison entre les mesures par IRM et la référence numérique permet d'objectiver le niveau de confiance que l'opérateur ou le clinicien peut accorder au résultant d'une imagerie IRM 4D flow.

Le fantôme physique muni de capteurs de pression est alimenté par une pompe contrôlée par un système de vérification de débit indépendant. Ceci permet de garantir expérimentalement les conditions d'écoulement modélisées numériquement.

La partie « fantôme physique » est placée au centre du tunnel IRM, à la place du patient.

En résumé, l'invention consiste à construire à partir d'un même et unique fichier numérique de CAO :

a) un modèle numérique du fantôme par un traitement numérique du fichier de CAO

b) un fantôme physique à partir du fichier de CAO, par exemple par impression additive.

Cela permet d'assurer au moins un couple indissociable « modèle numérique/modèle physique ».

Pour procéder à une évaluation d'un équipement, on place le modèle physique (le fantôme) dans l'IRM et on l'alimente avec le flux de référence qui sera déterminé en fonction de l'utilisation clinique de la séquence d'imagerie programmée sur l'IRM en évaluation.

On procède ensuite à une comparaison qui comprend pour exemple les étapes suivantes :

- Recalage géométrique des volumes d'imagerie et de modélisation numérique,
- dé-bruitage classique des données d'imagerie IRM,
- Moyenne temporelle des solutions numériques instantanées obtenues par CFD pour construire un cycle de référence,
- Échantillonnage d'un domaine numérique tétraédrique vers un domaine d'imagerie voxélisé et vice-versa,
- De comparaison point par point des paramètres disponibles lors de la mesure (magnitude de la vitesse locale, vecteurs selon la direction de l'écoulement).

Cette comparaison point par point permet de quantifier l'erreur que le système (appareil_IRM + séquence_IRM) fait quand il mesure une réalité physique connue a priori.

La méthodologie regroupe l'ensemble des opérations destinées à évaluer les performances indiquées par le fabricant du dispositif d'imagerie par résonance magnétique en ce que:

- on dispose d'une solution de référence obtenue par CFD (acronyme de « computational fluid dynamics ») pour un écoulement complexe. Cette technologie permet l'évaluation de nombreux paramètres du flux comme les champs des vitesses et des pressions endovasculaires.
- on utilise le fantôme proposé pour évaluer le dispositif d'imagerie par un objet test indépendant du constructeur de l'appareil d'imagerie.
- on effectue des mesures vélocimétriques au sein du fantôme IRM à partir de la séquence de flux 4D implémentée et utilisée en clinique sur l'appareil en question.
- on post-traite les données CFD et les mesures vélocimétriques par IRM de flux 4D afin de rendre les deux modalités comparables - correction des artéfacts de mesures, dégradation spatio-temporelle.
- on quantifie les écarts des mesures IRM par rapport à la référence (CFD) à partir d'un ou plusieurs indicateurs de qualité.

## Création du couple modèle numérique / modèle physique

L'invention n'est pas limitée à une forme particulière de fantôme et la forme décrite dans ce qui suit constitue un simple exemple non limitatif. L'objectif n'étant pas de reproduire la géométrie des parois artérielles spécifiques au patient, mais de rassembler plusieurs caractéristiques impliquant des complexités topologiques observées in vivo, afin de mettre en évidence les aspects importants du flux sanguin tout en gardant un fantôme de flux relativement compact et bien contrôlé.

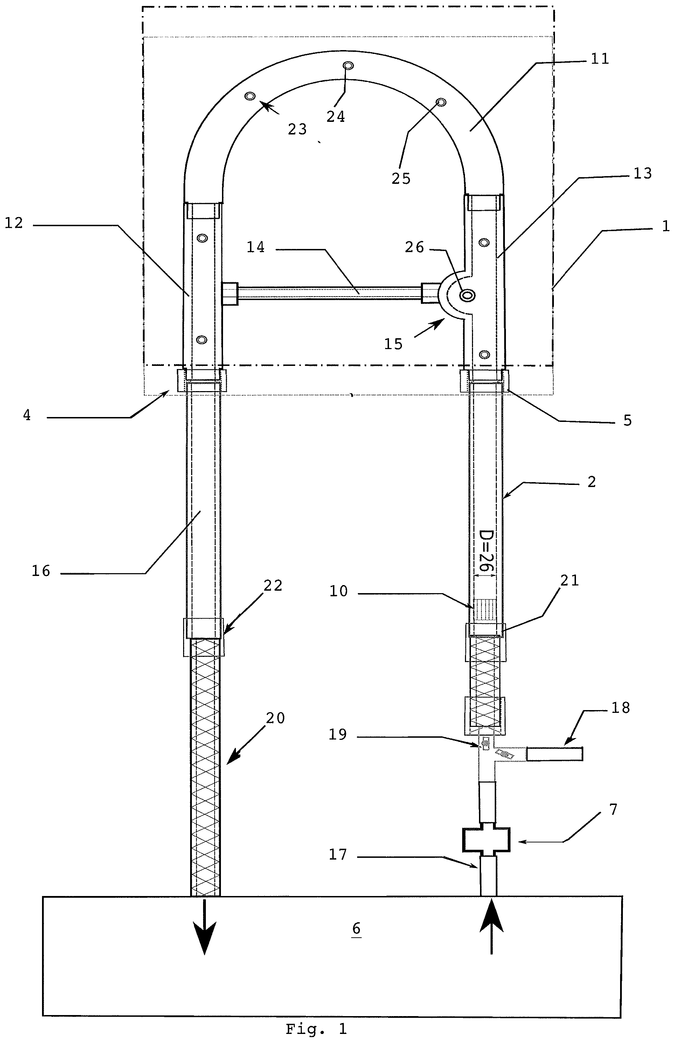

La figure 1 représente un exemple d'une configuration géométrique d'un fantôme de flux (1), présentant une forme générale de U avec une zone recourbée (11) de section circulaire constante prolongée de part et d'autre par deux branches (12, 13). Ces deux branches (12, 13) sont reliées par un conduit transversal (14) avec un volume hémisphérique d'entrée (15) simulant un anévrisme. Les branches du U (12, 13) présentent un connecteur d'entrée (5) et un connecteur de sortie (4).

Le fantôme (1) est raccordé à un tube rigide d'entrée (2) pour l'alimentation d'un fluide pulsé provenant d'une pompe (6) et par un tube rigide de sortie (16). La longueur de ces tubes (2, 16) est typiquement de 80 centimètres, avec une section de 26 millimètres. Ils sont reliés à la pompe (6) par des conduits flexibles (17, 20) par l'intermédiaire de connecteurs (21, 22).

Le tube d'alimentation (2) comprend un stabilisateur d'écoulement type « nid d'abeille » (10) supprimant les turbulences du flux pénétrant dans le fantôme (1). Il comprend aussi un robinet de purge (18) et une vanne (19).

Un débitmètre (7) est placé en série pour contrôler le débit réel instantané alimentant le fantôme (1).

Le fantôme possède des ouvertures ou sont connectés des capteurs de pression. Des exemples sont donnés à la partie recourbée (11) avec des capteurs (23 à 25) mais il y a aussi sur les branches latérales (12, 13) ainsi que la cavité (15), qui présente également un point de mesure de pression locale (26).

La forme est choisie pour générer un flux complexe et réaliste, tel que celui observé dans la grande circulation (aorte-coeur) du système cardiovasculaire.

Le diamètre intérieur du fantôme (1) est de 26 mm et a été conçu avec un rayon de courbure de 50 mm pour imiter les flux sanguins de l'arche aortique.

Une branche collatérale (14) a été établie par analogie avec les artères collatérales.

La taille de cette branche collatérale a été conçue pour reproduire le dédoublement observé in vivo entre l'aorte et les artères du tronc supra-aortique, coeliaque, les artères rénales et iliaques.

Enfin, la protubérance (15) attachée à l'intersection entre la branche collatérale (14) et la branche principale (13) simule les flux sanguins dans les anévrismes aortiques, mais aussi permet d'apprécier les tourbillons présents dans les cavités cardiaques.

La forme du fantôme est d'abord réalisée numériquement avec un logiciel de conception assisté par ordinateur. Le fichier de CAO constitue alors la base numérique pour préparer d'une part un fantôme hémodynamique numérique et d'autre part le fantôme physique, par une technique d'impression 3D basée sur la stéréolithographie.

La stéréolithographie permet de réaliser des modèles physiques complexes avec d'excellentes conditions de surface et une tolérance géométrique de l'ordre de $25 \mu m$ à la date de publication de ce document. Cette fidélité entre la géométrie du modèle CAO et le modèle physique réel permet de garantir le couple numérique/physique en termes d'équivalence géométrique. D'autres modèles obtenus par segmentation sur les images médicales sont tributaires de la résolution spatiale des images et du caractère voxelisé des données. C'est la raison pour laquelle il est indispensable de partir du modèle CAO vers le modèle physique afin de préserver l'équivalence géométrique.

Le fantôme physique est placé dans l'équipement IRM, à la place du patient, après avoir été disposé dans une poche remplie d'un gel. Il est alimenté par un circuit comprenant une pompe (6) et un débitmètre (7) ainsi qu'un réservoir tampon (8). La pompe (6) est commandée par ordinateur pour fournir des formes d'ondes reproductibles dans le temps et conformes au modèle numérique défini par dans l'écoulement de référence. Le fluide a des caractéristiques hydrodynamiques voisines à celles du sang dans la grande circulation : viscosité = 4 cPoi et densité = 1020 kg/m$^3$.

La pompe délivre un débit pulsé qui est contrôlé à tout instant par le débitmètre (7). Les capteurs de pression permettent de valider les cartographies de pression hydrostatique reconstruites à partir des cartes de vitesse.

Pour réduire le mouvement tourbillonnant du fluide entrant, un « nid d'abeille » (10) permet de rendre le flux laminaire à l'entrée de la région d'intérêt.

Diagramme fonctionnel

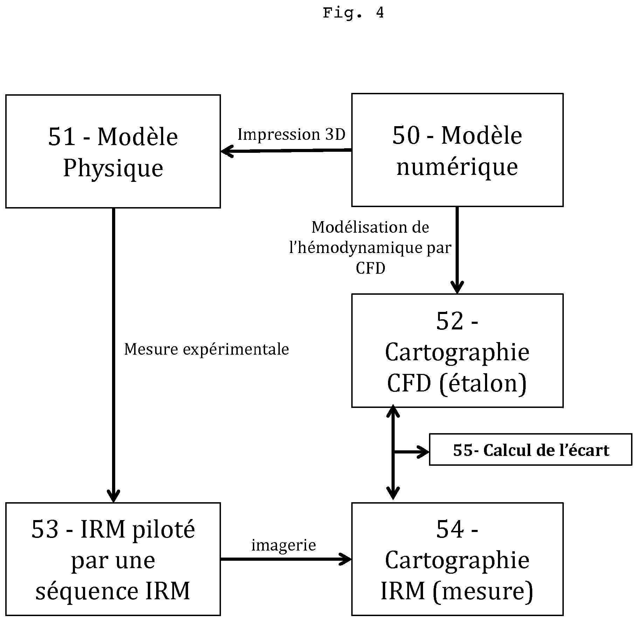

La figure 4 illustre le diagramme fonctionnel de l'invention.

On prépare un modèle numérique (50) composé d'une géométrie (1) et des conditions d'écoulement.

On fabrique par impression 3D un fantôme physique (51) à partir de la géométrie CAO du modèle numérique.

A partir du modèle numérique on génère une cartographie CFD par modélisation de l'hémodynamique conforme au modèle numérique (52). Cette cartographie sert de référence (étalon).

On place le modèle physique dans l'IRM, on alimente le système avec les conditions d'écoulement fixées par le modèle numérique et on lance la ou les séquences d'acquisitions 4D flow (53) qui pilotent l'acquisition. Alimenté avec les paramètres conformes au modèle numérique, le fantôme et son système d'alimentation reproduit à l'identique l'hémodynamique de référence et l'IRM génère une cartographie IRM (54) qui est la mesure expérimentale du phénomène. On enregistre aussi les données de la séquence IRM à valider.

On met en forme les données des cartographies IRM et CFD pour être comparées. Par corrélation des deux volumes de données on procède au calcul des écarts (55) entre l'étalon et la mesure. Ces traitements permettent d'établir les écarts (55) sur des marqueurs utiles de la spécialité.

Ces informations permettent ensuite au praticien d'apprécier le degré de confiance qu'il peut accorder à une acquisition d'une image sur un patient avec la même séquence IRM.

Résultats expérimentaux

A titre d'exemple, on a placé le fantôme dans un équipement IRM piloté avec une séquence 4D Flow optimisée avec les réglages suivants :

Vitesse d'encodage VENC = 0,5 m / s dans les trois directions d'encodage de la vitesse;

```
Temps d'écho TE = 3,43-3,5 ms;

Résolution temporelle = 49-52 ms;

Angle de basculement = 15 °.
```

Les mesures de vélocité sont corrigées pour tenir compte des effets de volume partiel causés par les parois du fantôme et du bruit aléatoire sur les images de phase dû à l'air environnant le fantôme.

Le fluide imitant le sang a été modélisé sous la forme d'un fluide newtonien incompressible de viscosité ciné-matique $\nu = 4,02 \times 10\text{-}6$ m$^2$/s. (4cPoi)

Le solveur Yales2bio a été utilisé pour résoudre les équations de mécanique de fluides.

Une condition limite d'entrée de flux est imposée en entrée, elle représente le débit de référence. Une condition limite de sortie de type convective a été imposée de telle sorte qu'elle garantit la conservation de la masse pour l'ensemble du domaine d'écoulement.

Toutes les parois étaient supposées rigides, en accord avec le matériau choisi pour la fabrication du fantôme, et une condition de non-glissement était prescrite (vitesse=0 à la paroi).

Afin de s'assurer d'imposer le bon profil d'écoulement (2D) à l'entrée du domaine numérique lors du calcul CFD, la répartition relative des vitesses a été ajustée basée sur l'image d'une acquisition par contraste de phase en mode 2D, mesurée à l'entrée du fantôme et perpendiculaire au flux. Cette acquisition est indépendante à l'acquisition 4D flow et permet de corriger les décalages de la forme d'onde créée par l'impédance contenue par la série de tuyaux entre la pompe et le fantôme. Le débitmètre garantie la valeur absolue du débit et la série 2D permet de lui donner la bonne répartition à l'entrée du domaine numérique. Cette boucle de contrôle permet de garantir une parfaite équivalence entre les profils d'entrée utilisés dans le domaine numérique et ceux présent dans le domaine physique.

Moyenne temporelle de la solution numérique pour construire le champ de référence

Lors d'une exploration par IRM 4D Flow, le signal IRM est construit pendant plusieurs centaines de cycles cardiaques. A titre d'exemple, une acquisition centrée sur le coeur peut durer 15 minutes et une acquisition au niveau du cerveau peut durer 45 minutes d'acquisition. Pendant ce temps le signal IRM permet de reconstruire un seul cycle représentatif de l'hémodynamique caractéristique de la région étudiée. Pour sa part, la modélisation par mécanique des fluides va proposer des solutions instantanées qui ne sont pas exactement identiques car elles vont tenir compte des fluctuations et instabilités présente dans les écoulements complexes (tourbillons). Afin de reconstruire une solution numérique équivalente à celle qui est mesurée par l'IRM, toutes les simulations ont été effectuées pendant 40 cycles, en moyenne sur les 30 derniers cycles après suppression des 10 premiers cycles pour annuler l'effet de la condition initiale arbitrairement sélectionnée.

Les cartographies de vitesses modélisées par CFD (gauche) et mesurée par IRM (à droite) sont présentées en figure 4.

Échantillonnage des champs de vitesse CFD

Deux méthodes classiques peuvent être adoptées pour comparer les champs de vitesse CFD et IRM entre eux : les champs de vitesse IRM voxélisés peuvent être interpolés sur le maillage tétraédrique CFD haute résolution (appelée HR-CFD), ou les vitesses HR-CFD, localisées sur les nœuds du maillage tétraédrique peuvent être prises en compte dans le voxel des images IRM, pour obtenir un champ voxélisé avec les valeurs de vitesse CFD sous échantillonnées, appelée CFD basse résolution (LR-CFD).

Cette dernière méthode est apte pour étudier les erreurs sur la mesure du débit. Elle est pondérée par rapport aux volumes des tétraèdres inclus dans le voxel reconstruit.

Dans l'exemple donné, les champs de vitesse ont été comparés qualitativement aux mesures d'IRM de 2 mm de taille de voxel isotrope. Les cartes de vitesse révèlent une excellente concordance et montrent des écoulements très similaires même en cas de motifs complexes, comme c'est le cas dans l'anévrisme.

Une analyse statistique des différences de vitesse dans l'ensemble du domaine segmenté entre LR-CFD et 4D Flow IRM (taille de voxel de 2 mm) a été réalisée, pour chaque composante de vitesse.

Pour cette analyse, la solution CFD a été sous-échantillonnée vers le domaine de l'IRM, moyennée en phase, et les vitesses des voxels chevauchant la paroi ont été mises à zéro. Toutes les corrélations se sont révélées statistiquement significatives ($p < 10-7$). Une excellente corrélation a été trouvée pour les deux principales composantes de la vitesse (tête-pied et droite gauche).

La troisième composante était moins bien représentée par le manque de résolution en contraste fixée par l'imagerie (la vitesse maximale dans cette direction était trop faible comparée à la vitesse d'encodage choisie pour cette mesure).

L'exemple présenté ici a été utilisé comme preuve de concept et validation de la méthode, les corrélations des composantes de vitesse sont excellentes sur cette séquence optimisée et voisines de 96 % de confiance pour l'ensemble des cartographies de vitesse sur ce système d'imagerie (appareil IRM + séquence IRM).

**Revendications**

1. - Procédé de test d'un équipement d'Imagerie par Résonance Magnétique (IRM) exécutant une séquence d'imagerie de flux par IRM à contraste de phase dite "4D flow" en présence d'un fantôme qui présente un écoulement de référence afin de tester la performance des mesures de vélocimétrie obtenues quand on utilise en clinique ladite séquence "4D flow", par la caractérisation d'un degré de confiance sur les mesures de vélocimétrie, ledit écoulement de référence étant réel et parfaitement connu par modélisation par mécanique des fluides numérique, comportant une étape d'imagerie du fantôme **caractérisé en ce que** :

   a) on définit un fichier numérique de conception du fantôme qui présente l'écoulement de référence, et on réalise à partir de ce fichier numérique un couple de référence formé par un fantôme numérique obtenu par traitement numérique dudit fichier de conception et un fantôme physique réalisé par un procédé de fabrication piloté par ledit fichier numérique de conception,

   b) on procède à une modélisation des données de flux IRM par acquisition par résonance magnétique d'une cartographie numérique du champ de vitesses dans le volume exploré, obtenue par la séquence "4D flow" à caractériser, des trois composantes de la vitesse au cours du temps du fantôme numérique soumis à une séquence d'alimentation fluidique de référence pour enregistrer un premier fichier de données numériques de référence, et enregistrer les paramètres d'alimentation fluidique de référence afin de générer l'écoulement de référence,

   c) on procède à une acquisition des données de flux IRM par acquisition par résonance magnétique d'une cartographie numérique du champ de vitesses dans le volume exploré des trois composantes de la vitesse au cours du temps par l'équipement IRM piloté par la séquence "4D flow" à caractériser, du fantôme physique alimenté avec ladite séquence d'alimentation fluidique de référence, pour enregistrer un second fichier de données numériques mesurées expérimentalement, l'alimentation étant pilotée par lesdits paramètres d'alimentation fluidique de référence,

   d) Après avoir effectué les étapes de recalage, correction et mise en forme des données, étapes nécessaires à la compatibilité spatio-temporelle, on procède à une comparaison desdits fichiers de données numériques pour calculer au moins un indicateur d'erreur représentatif des différences entre lesdits fichiers numériques et représentatif de la performance des mesures de vélocimétrie acquises sur l'équipement IRM par la séquence "4D flow" pour l'écoulement de référence.

2. - Procédé selon la revendication 1 **caractérisé en ce que** ladite comparaison desdits fichiers de données numériques pour calculer au moins un indicateur d'erreur représentatif des différences entre lesdits fichiers numériques comprend les étapes suivantes :

   - Recalage géométrique des volumes d'imagerie et de modélisation numérique,
   - dé-bruitage classique des données d'imagerie IRM,
   - Moyenne temporelle des solutions numériques instantanées obtenues par CFD pour construire un cycle de référence,
   - Échantillonnage d'un domaine numérique tétraédrique vers un domaine d'imagerie voxélisé et vice-versa,

- comparaison point par point des paramètres disponibles lors de la mesure tels que la magnitude de la vitesse locale, et les vecteurs selon la direction de l'écoulement.

3. - Procédé selon la revendication 1 **caractérisé en ce que** ledit fantôme physique comporte au moins un capteur d'un paramètre d'alimentation fluidique.

4. - Procédé selon la revendication 1 **caractérisé en ce que** lesdits fantômes présentent une forme générale de U avec une zone recourbée (11) de section circulaire constante prolongée de part et d'autre par deux branches (12, 13) reliées par un conduit transversal (14) avec un volume hémisphérique d'entrée (15) et présentent un connecteur d'entrée (5) et un connecteur de sortie (4)

5. - Procédé selon la revendication 3 **caractérisé en ce que** ledit fantôme physique comporte au moins un capteur de pression.

6. - Procédé selon la revendication 3 **caractérisé en ce que** ledit fantôme physique comporte au moins un capteur de débit.

7. - Procédé selon la revendication 1 **caractérisé en ce que** ledit fantôme physique est placé dans un milieu aqueux.

**Patentansprüche**

1. Verfahren zum Testen eines Magnetresonanztomographiegeräts (MRT), das die "4D-Fluss"-Phasenkontrast-MRT-Flussbildgebungssequenz in Anwesenheit eines Phantoms durchführt, das eine Referenzströmung darstellt, um die Leistung der dabei erhaltenen Geschwindigkeitsmessungen zu testen, wenn die "4D-Fluss"-Sequenz in der Klinik verwendet wird, durch die Charakterisierung eines Vertrauensgrads in die Geschwindigkeitsmessungen, wobei die Referenzströmung real und durch die Modellierung des digitalen Fluids durch die Mechanik perfekt bekannt ist, umfassend einen Schritt zur Abbildung des Phantoms, **dadurch gekennzeichnet, dass:**

    a) eine digitale Designdatei des Phantoms, welche die Referenzströmung darstellt, definiert wird und aus dieser digitalen Datei ein Referenzpaar erstellt wird, das aus einem digitalen Phantom, das durch digitale Verarbeitung der Designdatei erhalten wurde, und einem physischen Phantom, das durch einen Herstellungsprozess durch die digitale Designdatei erstellt wurde, gebildet wird,
    b) eine Modellierung der MRT-Flussdaten durch Magnetresonanzerfassung einer digitalen Karte des Geschwindigkeitsfeldes im untersuchten Volumen vorgenommen wird, die durch die zu charakterisierende "4D-Fluss"-Sequenz erhalten wurde, wobei die drei Komponenten der Geschwindigkeit im Laufe der Zeit des digitalen Phantoms einer Referenzfluidversorgungssequenz ausgesetzt werden, um eine erste Referenzdatei mit digitalen Daten aufzuzeichnen und die Referenzfluidversorgungsparameter aufzuzeichnen, um den Referenzfluss zu erzeugen,
    c) die MRT-Flussdaten durch Magnetresonanzerfassung einer digitalen Karte des Geschwindigkeitsfeldes im untersuchten Volumen der drei Geschwindigkeitskomponenten im Laufe der Zeit durch das MRT-Gerät, das durch die zu charakterisierende "4D-Fluss"-Sequenz gesteuert wird, des physischen Phantoms, das mit der Referenzfluidversorgungssequenz versorgt wird, erfasst werden, um eine zweite Datei mit experimentell gemessenen digitalen Daten aufzuzeichnen, wobei die Versorgung durch die Referenzfluidversorgungsparameter gesteuert wird,
    d) nachdem die für die räumlich-zeitliche Kompatibilität notwendigen Schritte der Registrierung, Korrektur und Formatierung der Daten durchgeführt wurden, ein Vergleich der Dateien mit den digitalen Daten durchgeführt wird, um mindestens einen Fehlerindikator zu berechnen, der für die Unterschiede innerhalb der digitalen Dateien repräsentativ ist, und für die Leistung der auf dem MRT-Gerät erfassten Geschwindigkeitsmessungen durch die "4D-Fluss"-Sequenz für den Referenzfluss repräsentativ ist.

2. Verfahren nach Anspruch 1 , **dadurch gekennzeichnet, dass** der Vergleich der Dateien mit den digitalen Daten zum Berechnen mindestens eines Fehlerindikators, der für die Unterschiede innerhalb der digitalen Dateien repräsentativ ist, die folgenden Schritte umfasst:

    - geometrische Registrierung der digitalen Bild- und Modellierungsvolumina,
    - klassisches Entrauschen der MRT-Bilddaten,
    - zeitliches Mittel der durch CFD erhaltenen momentanen digitalen Lösungen zum Erstellen eines Referenzzyklus,
- Abtastung einer tetraedrischen digitalen Domäne zu einer voxelisierten Bildgebungsdomäne und umgekehrt,
- Punkt-für-Punkt-Vergleich der während der Messung verfügbaren Parameter, wie der Größe der lokalen Geschwindigkeit, und der Vektoren entsprechend der Strömungsrichtung.

3. Verfahren nach Anspruch 1, **dadurch gekennzeichnet, dass** das physikalische Phantom mindestens einen Sensor für einen Fluidversorgungsparameter umfasst.

4. Verfahren nach Anspruch 1, **dadurch gekennzeichnet, dass** die Phantome eine allgemeine U-Form mit einer gekrümmten Zone (11) mit konstantem kreisförmigen Querschnitt aufweisen, die auf beiden Seiten durch zwei Zweige (12, 13) verlängert wird, die durch eine Querleitung (14) mit einem halbkugelförmigen Einlassvolumen (15) verbunden sind und einen Einlassanschluss (5) und einen Auslassanschluss (4) aufweisen.

5. Verfahren nach Anspruch 3, **dadurch gekennzeichnet, dass** das physische Phantom mindestens einen Drucksensor umfasst.

6. Verfahren nach Anspruch 3, **dadurch gekennzeichnet, dass** das physische Phantom mindestens einen Durchflusssensor umfasst.

7. Verfahren nach Anspruch 1, **dadurch gekennzeichnet, dass** das physische Phantom in einer wasserhaltigen Umgebung platziert ist.

## Claims

1. Method for testing magnetic resonance imaging (MRI) equipment that executes a phase contrast MRI flow imaging sequence, referred to as "4D flow", in the presence of a phantom which has a reference flow, in order to test the performance of velocimetry measurements which are obtained when said "4D flow" sequence is used in clinical practice, by characterizing a degree of confidence in the velocimetry measurements, said reference flow being real and well known by computational fluid mechanics modeling, comprising a phantom imaging step **characterized in that:**

   a) a digital phantom design file is defined, which has the reference flow, and a reference pair is produced from this digital file, which pair is formed by a digital phantom which is obtained through digital processing of said design file and a physical phantom produced by a production method which is controlled by said digital design file,
   b) MRI flow data are then modelled by acquiring, by magnetic resonance, a digital map of the velocity field in the volume explored, which map is obtained by the "4D flow" sequence to be characterized, of the three components of the velocity over time of the digital phantom subjected to a reference fluidic supply sequence in order to record a first digital data reference file, and record the reference fluidic supply parameters in order to generate the reference flow,
   c) MRI flow data are then acquired by acquiring, by magnetic resonance, a digital map of the velocity field in the volume explored of the three components of the velocity over time by the MRI equipment controlled by the "4D flow" sequence to be characterized, of the physical phantom supplied with said reference fluidic supply sequence, in order to record a second file of experimentally measured digital data, the supply being controlled by said reference fluidic supply parameters,
   d) after performing the steps of resetting, correcting and formatting the data, which steps are required for space-time compatibility, said digital data files are then compared to calculate at least one error indicator representative of the differences between said digital files and representative of the performance of the velocimetry measurements acquired on the MRI equipment by the "4D flow" sequence for the reference flow.

2. Method according to claim 1, **characterized in that** said comparison of said digital data files to calculate at least one error indicator representative of the differences between said digital files comprises the following steps:

   - geometric resetting of imaging volumes and digital modeling volumes,
   - conventional denoising of MRI imaging data,
   - time average of instantaneous digital solutions which are obtained by CFD to build a reference cycle,
   - sampling from a tetrahedral digital domain to a voxelized imaging domain and vice versa,
   - point-by-point comparison of the parameters available at the time of measurement, such as local velocity magnitude and vectors along the flow direction.

3. Method according to claim 1, **characterized in that** said physical phantom comprises at least one sensor for a fluidic supply parameter.

4. Method according to claim 1, **characterized in that** said phantoms are generally U-shaped with a curved zone (11) with a consistently circular cross-section which is extended on either side by two branches (12, 13) which are connected by a transverse duct (14) with a hemispherical inlet volume (15) and which have an inlet connector (5) and an outlet connector (4).

5. Method according to claim 3, **characterized in that** said physical phantom comprises at least one pressure sensor.

6. Method according to claim 3, **characterized in that** said physical phantom comprises at least one flow sensor.

7. Method according to claim 1, **characterized in that** said physical phantom is located in an aqueous medium.

Fig. 1

Fig. 2

Fig. 3

Fig. 4

```
┌─────────────────┐   Impression 3D    ┌─────────────────┐
│  51 - Modèle    │ ◄───────────────── │  50 - Modèle    │
│   Physique      │                    │   numérique     │
└────────┬────────┘                    └────────┬────────┘
         │                                      │
         │                          Modélisation de
         │                          l'hémodynamique par
         │                                CFD
         │                                      │
         │                                      ▼
         │                             ┌─────────────────┐
  Mesure expérimentale                 │     52 -        │
         │                             │  Cartographie   │
         │                             │  CFD (étalon)   │
         │                             └────────┬────────┘
         │                                      │▲
         │                                      ││──► ┌──────────────────────┐
         │                                      ││    │ 55- Calcul de l'écart│
         │                                      ▼│    └──────────────────────┘
         ▼                                      │
┌─────────────────┐    imagerie       ┌─────────────────┐
│ 53 - IRM piloté │ ─────────────────►│     54 -        │
│    par une      │                   │  Cartographie   │
│  séquence IRM   │                   │  IRM (mesure)   │
└─────────────────┘                   └─────────────────┘
```

Fig. 5

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015109254 A
- WO 2017091835 A
- US 7063942 B
- US 6205871 B

**Littérature non-brevet citée dans la description**

- *Magn Reson Mater Phy,* 2015, vol. 28, 385-393
- **WEN CY ; YANG AS ; TSENG LY ; CHAI JW.** Investigation of pulsatile flowfield in healthy thoracic aorta models. *Ann Biomed Eng.,* 05 Novembre 2009, vol. 38 (2), 391-402
- **MORENO et al.** *flux 4D et mécanique des fluides numériques 'CFD' Paris 2017 Congrès international d'imagerie médicale,* 13 Octobre 2017
- **MARKL, M. et al.** Time-resolved three-dimensional phase-contrast MRI. *J. Magn. Reson. Imaging,* 2003, vol. 17, 499-506